# EUROPEAN PATENT APPLICATION

(11) **EP 1 976 036 A2**
(43) Date of publication of application: **01.10.2008**
(21) Application number: 08005056.0
(22) Date of filing: 18.03.2008
(51) Int. Cl.: H01L 41/09

(54) **Actuator**

(30) Priority: 30.03.2007 JP 2007093926; 19.09.2007 JP 2007242022
(71) Applicant: TOKAI RUBBER INDUSTRIES, LTD., Komaki-shi, Aichi-ken, 485-8550 (JP)
(72) Inventor: Ishiguro, Tadashi, Ashikaga-shi Tochigi-ken 326-0331 (JP); Ito, Hiroaki, Komaki-shi Aichi 485-8550 (JP); Hashimoto, Kazunobu, Komaki-shi Aichi 485-8550 (JP); Yoshikawa, Hitoshi, Komaki-shi Aichi 485-8550 (JP); Nozawa, Akitoshi, Komaki-shi Aichi 485-8550 (JP); Tamura, Makoto, Komaki-shi Aichi 485-8550 (JP); Guo, Shijie, Komaki-shi Aichi 485-8550 (JP); Komatsu, Takahiro, Komaki-shi Aichi 485-8550 (JP)
(74) Representative: Kuhnen & Wacker

(57) **Abstract**

To provide an actuator which is easily made a small size and flexible, and has a large displacement. The actuator comprises a rod-shaped actuator element, having one axial end thereof fixed, including a dielectric film made of a dielectric elastomer and a plurality of electrodes arranged via the dielectric film, in the actuator element, the dielectric film extends as a voltage applied across the electrodes becomes large, and a load member connected to the other axial end of the actuator element and fixed in a state in which the actuator element is permitted to be extended axially, characterized in that making large the voltage applied across the electrodes causes the dielectric film to be extended, whereby the actuator element is extended axially according to the tension of the load member .

## Description

### BACKGROUND OF THE INVENTION

### Field of the Invention

The present invention relates to an actuator for outputting a drive force by extending/contracting a dielectric film according to an applied voltage.

### Description of the Related Art

For example, Japanese Unexamined Patent Publication (KOKAI) No.2006-520180 discloses a roll-type actuator as an electrostrictive type actuator using a dielectric elastomer. That is, the actuator described in Japanese Unexamined Patent Publication (KOKAI) No. 2006-520180 is configured by winding an actuator element having a dielectric elastomer film and electrodes on the outer periphery of a compressed coil spring. Applying a voltage to the electrodes of the actuator element causes the film thickness of the dielectric elastomer film to become small and extend axially. This causes the binding force to the coil spring to become small, whereby the coil spring, that is, the actuator extends axially.

Also, Japanese Unexamined Patent Publication (KOKAI) No.2003-230288 discloses an actuator which includes a tube-shaped actuator element consisting of a dielectric elastomer film and electrodes. Applying a voltage to the electrodes of the actuator element causes the film thickness of the dielectric elastomer film to become small and extend axially, similarly to the actuator described in above-mentioned Japanese Unexamined Patent Publication (KOKAI) No.2006-520180. This causes the actuator to extend axially.

For the actuator described in Japanese Unexamined Patent Publication (KOKAI) No.2006-520180, when a voltage is applied to cause the actuator element to extend, the coil spring arranged in the inside diameter of the actuator element extends without changing the diameter thereof. Hence, when extended, the actuator element can interfere with the coil spring to prevent the actuator from being displaced axially. Conversely, the voltage application is stopped to cause the actuator element to be contracted axially. The binding force from the actuator element thus contracted causes the coil spring to be compressed axially. Here, when contracted, the film thickness of the dielectric elastomer having become small by applying a voltage becomes large in order to restore the original thickness thereof. On the other hand, the coil spring contracts without changing diameter thereof. Hence, when contracted, the actuator element can interfere with the coil spring to cause, for example, the actuator element to be caught into the pitch of the coil spring. Also, the actuator described in Japanese Unexamined Patent Publication (KOKAI) No.2006-520180 uses a coil spring as a core material. Hence, it is difficult to make the actuator thin and small. Furthermore, since the coil spring is rigid body, it has difficulty to embody a flexible movement.

Also, for the actuator described in Japanese Unexamined Patent Publication (KOKAI) No.2003-230288, the actuator displaces to an extent that the actuator element extends from the natural state thereof. However, in the actuator, a member is not arranged which orients the extending direction of the actuator element. Hence, with the actuator, it is difficult to arrange the extending direction in one direction. Thus, the axial displacement is small.

### SUMMARY OF THE INVENTION

The present invention has been developed in view of such circumstance, and it is an object of the present invention to provide an actuator which is easily made a small size and flexible, and has a large displacement.

(1) In order to solve the above-mentioned problems, the actuator of the present invention comprises: a rod-shaped actuator element, having one axial end thereof fixed, including a dielectric film made of a dielectric elastomer and a plurality of electrodes arranged via said dielectric film, in said actuator element, said dielectric film extends as a voltage applied across said electrodes becomes large; and a load member connected to the other axial end of said actuator element and fixed in a state in which said actuator element is permitted to be extended axially; characterized in that making large the voltage applied across said electrodes causes said dielectric film to be extended, whereby said actuator element is extended axially according to the tension of said load member (corresponding to claim 1).

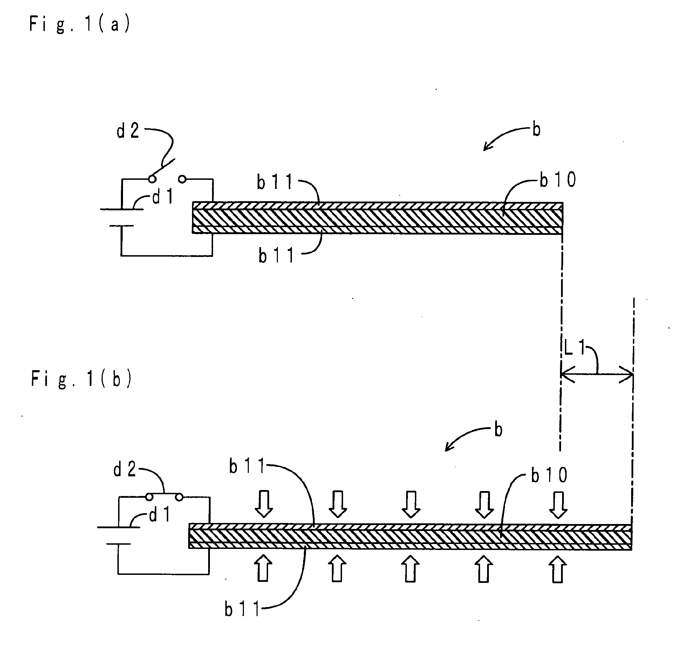

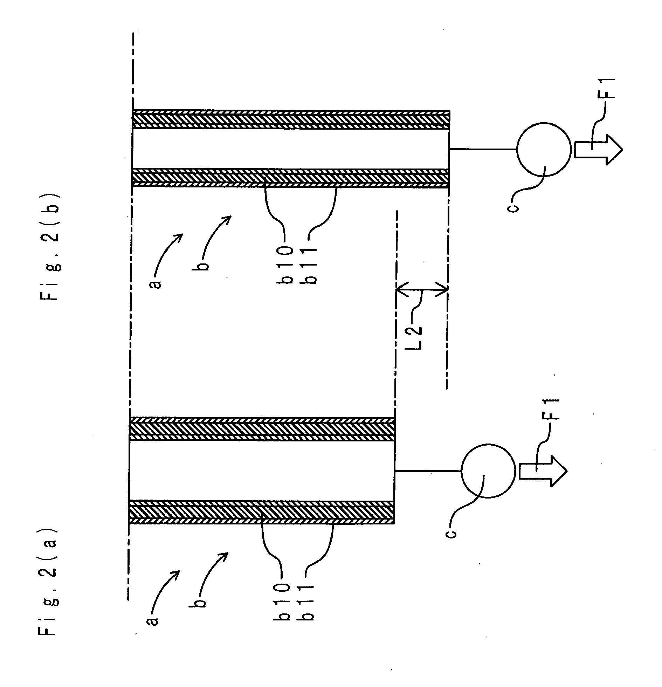

Hereinafter, the movement of the actuator of the present invention will be explained using principle figures, provided that Figs. 1 and 2 shown below are used to merely explain the movement of the actuator of the present invention, and there is nothing to limit the construction, shape, drive direction and the like of the actuator of the present invention. For example, the number of laminations of dielectric film, the thickness of electrodes or dielectric film, the number of electrodes arranged, the presence or absence of core material, and the like are not limited at all.

First, Fig. 1 shows a principle view of the actuator element of the actuator of the present invention. Fig. 1 (a) shows a state before voltage application; and Fig. 1 (b) shows a state during voltage application. As shown in Fig. 1, an actuator element b includes a dielectric film b10 and electrodes b11. The electrodes b11 are arranged on both the sides of the dielectric film b10. The electrodes b11 configure an electric circuit together with a switch d2 and a power source d1. As shown Fig. 1(b), closing the switch d2 causes a voltage to be applied across the electrodes b11. This causes the electrostatic attractive force between the electrodes b11 to become large. Hence, as shown by the white-blanked arrow in Fig. 1 (b), the dielectric film b10 deforms so as to contract in the film thickness direction. And, the dielectric film b10 deforms so as to extend in the surface expanding direction. Thus, the actuator element b extends by the distance L1 in the surface expanding direction.

Then, Fig. 2 shows a principle view of the actuator of the present invention using the actuator element b of Fig. 1. Fig. 2 (a) shows a state before voltage application; and Fig. 2 (b) shows a state during voltage application. As shown in Fig. 2, an actuator a includes the actuator element b and a load member c. The electrodes b11 are arranged on both the sides of the dielectric film b10. The dielectric film b10 is wound into tube-shape. The load member c is hung from the lower-end of the actuator element b. Hence, a downward tension F1 due to the weight of the load member c is applied to the actuator element b. The actuator element b is fixed in a state in which it is extended axially by the load member c. In other words, the upward restoring force of the actuator element b is balanced with the downward tension F1.

Applying a voltage across the electrodes b11 in this state causes the above-mentioned balance state to be unbalanced, whereby the actuator element b extends by the distance L1 as shown in the above-mentioned Fig. 1 (b). Hence, the actuator a extends by a distance L2 by the tension F1. Conversely, removing the voltage application causes the actuator element b to try to return to substantially original balancing state, whereby the actuator element b having extended contracts. Hence, the actuator a contracts by the distance L2 against the tension F1. In this way, the actuator a of the present invention outputs a drive force.

With the actuator of the present invention, the extending direction of the actuator element (the dielectric film) is oriented axially by the load member. Hence, the axial displacement is large. Also, a stable movement becomes possible regardless of the attitude of the actuator. Also, essential components of the actuator element are a dielectric film and electrodes, but not a coil spring as a core material. Hence, the actuator is easy to achieve a small size. Also, by changing the arranging method, shape, kind and film thickness of the dielectric film, the number and arrangement of the pair of electrodes, the tension of the load member, and the like, the drive force, the displacement and the like in the actuator of the present invention can be easily adjusted.

(2) Preferably, in the construction of the above (1), it is constructed that the above-mentioned load member is at least one of a weight and an elastic member (corresponding to claim 2). With this construction, the extending direction of the actuator element can be easily oriented. Also, the actuator of the present invention can be constructed at comparatively low cost.

(3) Preferably, in the construction of the above (1), it is constructed that the above-mentioned load member is the above-mentioned actuator element (corresponding to claim 3). That is, this construction is made by connecting a plurality of actuator elements. With this construction, a drive force can be outputted in both the forward and backward directions using a stoppage state (e.g., voltage application off state) as a reference.

(4) Preferably, in the construction of the above (1), it is constructed that the above-mentioned actuator element has a spiral extensible member formed by winding spirally an extensible film which includes the above-mentioned dielectric film, a pair of the above-mentioned electrodes arranged on both the surfaces of the dielectric film, and an insulation film arranged on one of the surfaces of a pair of the electrodes (corresponding to claim 4).

The spiral extensible member is formed by winding spirally a predetermined extensible film. Hence, the construction of the actuator element is simple. Thus, the actuator of the present invention can be easily made. Also, the number of windings of the extensible film can be easily adjusted. This allows a desired drive force and the displacement to be easily obtained. Also, after the completion of the spiral extensible member, radially-adjacent electrodes are isolated from each other by the insulation film. Hence, the continuity between the radially -adjacent electrodes can be restrained.

(5) Preferably, in the construction of the above (1), it is constructed that the above-mentioned actuator element has a laminated extensible member formed by laminating alternately the above-mentioned dielectric film and the above-mentioned electrodes in concentric circular shape (corresponding to claim 5).

The laminated extensible member is formed by laminating alternately the above-mentioned dielectric film and the above-mentioned electrodes. Hence, the construction of the actuator element is simple. Thus, the actuator of the present invention can be easily made. Also, the number of laminates of the dielectric film can be easily adjusted. This allows a desired drive force and the displacement to be easily obtained. Also, the extension/contraction of each of the dielectric film thus laminated can be efficiently performed.

(6) Preferably, in the construction of the above (5), it is constructed that the above-mentioned laminated extensible member has a hollow cylindrical shape (corresponding to claim 6). With this construction, no deformation during driving can be restricted by the core material compared with a case where a core material is arranged in an axis part. Hence, a large displacement is easily obtained. Also, the actuator becomes lighter in weight. Also, when an external shock is applied, the actuator element is likely to deform to an extent that a space is established in the axis part. Hence, the shock is easily absorbed.

(7) Preferably, in the construction of the above (1), it is constructed that the above-mentioned actuator element has a core material which is arranged to an axis portion thereof and is elastically deformable axially (corresponding to claim 7). Arranging the core material to the axis portion causes the shape of the actuator element to be easily kept. Also, arranging the dielectric film and the electrodes around the core material located on the center allows the actuator element and thus the actuator of the present invention to be easily manufactured.

(8) Preferably, in the construction of the above (7), it is constructed that the above-mentioned core material is made of an elastomer (corresponding to claim 8).

The Poisson' s ratio of an elastomer is close to 0.5. Hence, volume change due to elastic deformation is hardly to occur. That is, when extended axially, the diameter is smaller, while when contracted, the diameter is larger. Hence, with this construction, when extended, interference between the core material and the electrodes or between the core material and the dielectric film is hardly to occur.

Also, with the elastomer, the core material having various sizes and shapes can be easily manufactured. For example, utilizing extrusion processing, spinning technique and the like, a thin and small core material is easily manufactured. This allows the actuator of the present invention to be made thin and small. Also, with the core material made of the elastomer, a more flexible movement can be embodied. In this way, with this construction, for example, the application to artificial muscle is easily performed.

(9) Preferably, in the construction of the above (7), it is constructed that the above-mentioned actuator element has a spiral tube member formed by winding spirally around the above-mentioned core material an extensible film which includes the above-mentioned dielectric film, a pair of the above-mentioned electrodes arranged on both the surfaces of the dielectric film, and an insulation film arranged on one of the surfaces of a pair of the electrodes (corresponding to claim 9).

The spiral tube member is formed by winding spirally around the core material a predetermined extensible film. Hence, the construction of the actuator element is simple. Thus, the actuator of the present invention can be easily made. Also, the number of windings of the extensible film can be easily adjusted. This allows a desired drive force and displacement to be easily obtained. Also, after the completion of the spiral tube member, radially-adjacent electrodes are isolated from each other by the insulation film. Hence, the continuity between the radially -adjacent electrodes can be restrained.

(10) Preferably, in the construction of the above (7), it is constructed that the above-mentioned actuator element has a laminated tube member formed by laminating alternately around the above-mentioned core material the above-mentioned dielectric film and the above-mentioned electrodes in concentric circular shape (corresponding to claim 10).

The laminated tube member is formed by laminating alternately around the core material the dielectric film and the electrodes. Hence, the construction of the actuator element is simple. Thus, the actuator of the present invention can be easily made. Also, the number of laminates of the dielectric film can be easily adjusted. This allows a desired drive force and displacement to be easily obtained. Also, the extension/contraction of each of the dielectric films thus laminated can be efficiently performed.

(11) Preferably, in the construction of any one of the above (1), it is constructed that the above-mentioned actuator element has a maximum diameter of less than 5 mm in a direction perpendicular to the axis (corresponding to claim 11).

The size in the axial direction and the axially-perpendicular direction of the actuator of the present invention is not particularly limited. For example, with this construction, a fine string-shaped actuator can be constructed in which the maximum diameter in a direction perpendicular to the axis of the actuator element is less than 5 mm. In this case, it can be driven at a lower voltage. Further, by making the maximum diameter in a direction perpendicular to the axis of the actuator element less than 0.5 mm, a thin fibrous actuator may be constructed. These string-shaped and fibrous actuators are suitable for artificial muscle.

(12) Preferably, in the construction of the above (1), it is constructed that a plurality of the above-mentioned actuator elements are bound and arranged (corresponding to claim 12).

Binding a plurality of the actuator elements allows a larger driving force to be outputted. Particularly, when the actuator element is of string-shape or fibrous, an aspect in which a plurality of the elements are bound to use is suitable.

(13) Preferably, in the construction of the above (12), it is constructed that at least one of a positive pole side and a negative pole side of the plurality of the above-mentioned electrodes of the above-mentioned bound actuator elements is shared in use (corresponding to claim 13). With this construction, the number of the electrodes arranged becomes fewer. Hence, the construction of the actuator element becomes simpler.

(14) Preferably, in the construction of the above (1), it is constructed that the above-mentioned electrodes are made of a mixed material comprised of an elastomer and conductive material (corresponding to claim 14).

When the electrode, together with the dielectric film, is hardly to expand/contract, the extension/contraction of the dielectric film is prevented by the electrodes. In this respect, with this construction, the electrodes are made of a mixed material containing a flexible elastomer, in addition to the conductive material. Thus, the electrode can extend/contract integrally with the dielectric film. Hence, the extension/contraction of the dielectric film is hardly to be hindered, and a desired displacement is easily obtained.

(15) Preferably, in the construction the above (1), it is constructed that the above-mentioned electrodes are liquid (corresponding to claim 15). Here, "liquid" means a concept including gel-like and paste state as well. With this construction, the deformation of the dielectric film during driving can be less restricted by the electrode. Also, when an external shock is applied, the electrode is fluidized or deformed, whereby the shock is easily absorbed.

### BRIEF DESCRIPTION OF THE DRAWINGS

A more complete appreciation of the present invention and many of its advantages will be readily obtained as the same becomes better understood by reference to the following detailed description when considered in connection with the accompanying drawings and detailed specification, all of which forms a part of the disclosure.
FIG. 1 (a) is a principle view of an actuator element in an actuator of the present invention, and shows a state before voltage application
FIG. 1 (b) is a principle view of an actuator element in an actuator of the present invention, and shows a state during voltage application.
Fig. 2 (a) is a principle view of an actuator of the present invention using the actuator element of Fig. 1, and shows a state before voltage application.
Fig. 2 (b) is a principle view of an actuator of the present invention using the actuator element of Fig. 1, and shows a state during voltage application.
Fig. 3 is a perspective view of the actuator of the first preferred embodiment of the present invention.
Fig. 4 is a perspective exploded view of the actuator element in the actuator.
Fig. 5 is an axially-perpendicularly sectional view of the actuator.
Fig. 6 is an axially sectional view of the actuator.
Fig. 7 is an axially sectional view of the actuator during voltage application.
Fig. 8 is an axially-perpendicularly sectional view of the actuator of the second preferred embodiment of the present invention.
Fig. 9 is an axially-perpendicularly sectional view of the actuator of the third preferred embodiment of the present invention.
Fig. 10 is a side view of the actuator of the fourth preferred embodiment of the present invention.
Fig. 11 is a side view of the actuator of the fifth preferred embodiment of the present invention.
Fig. 12 is a side view of the actuator of the sixth preferred embodiment of the present invention.
Fig. 13 is a perspective view of the actuator of the seventh preferred embodiment of the present invention.
Fig. 14 is a perspective exploded view of the actuator.
Fig. 15 is an axially sectional view of the actuator.
Fig. 16 is a perspective view of the actuator of the eighth preferred embodiment of the present invention.
Fig. 17 is a perspective exploded view of the actuator.
Fig. 18 is an axially sectional view of the actuator.
Fig. 19 is a partially-perspective view of the actuator of the ninth preferred embodiment of the present invention.
Fig. 20 is a partially-perspective view of the actuator of the tenth preferred embodiment of the present invention.
Fig. 21 is a partially-perspective view of the actuator of the eleventh preferred embodiment of the present invention.
Fig. 22 is a partially-perspective exploded view of the actuator.
Fig. 23 is a dimensional view of the laminated extensible member of the sample of example 1.
Fig. 24 is a graph for showing a relationship between applied voltage and displacement (axial displacement).
Fig. 25 is a graph for showing a relationship between applied voltage and output.

### DETAILED DESCRIPTION OF THE PREFERRED EMBODIMENT

Having generally described the present invention, a further understanding can be obtained by reference to the specific preferred embodiments which are provided herein for the purpose of illustration only and not intended to limit the scope of the appended claims.

### <First embodiment>

### [Constitution of actuator]

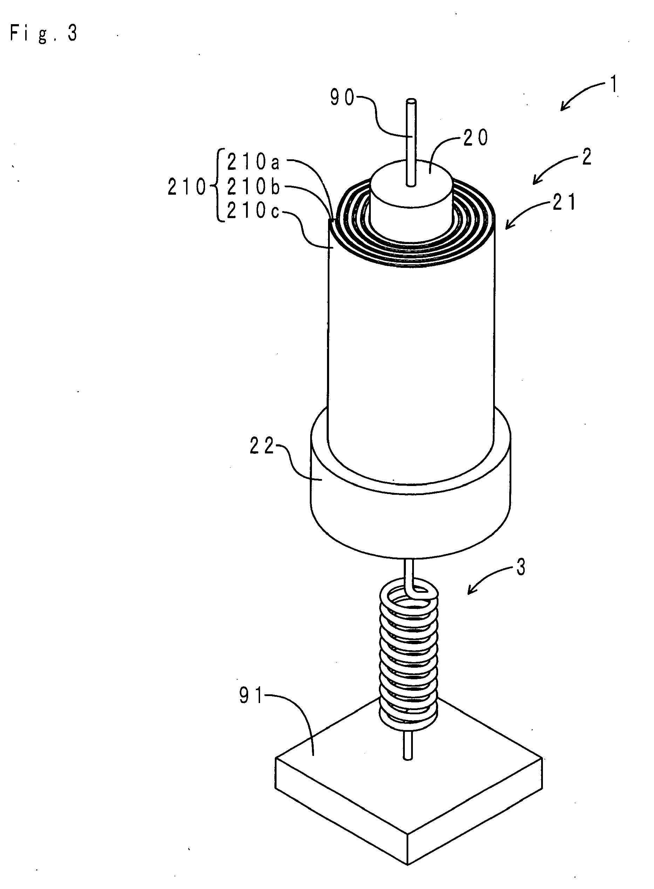

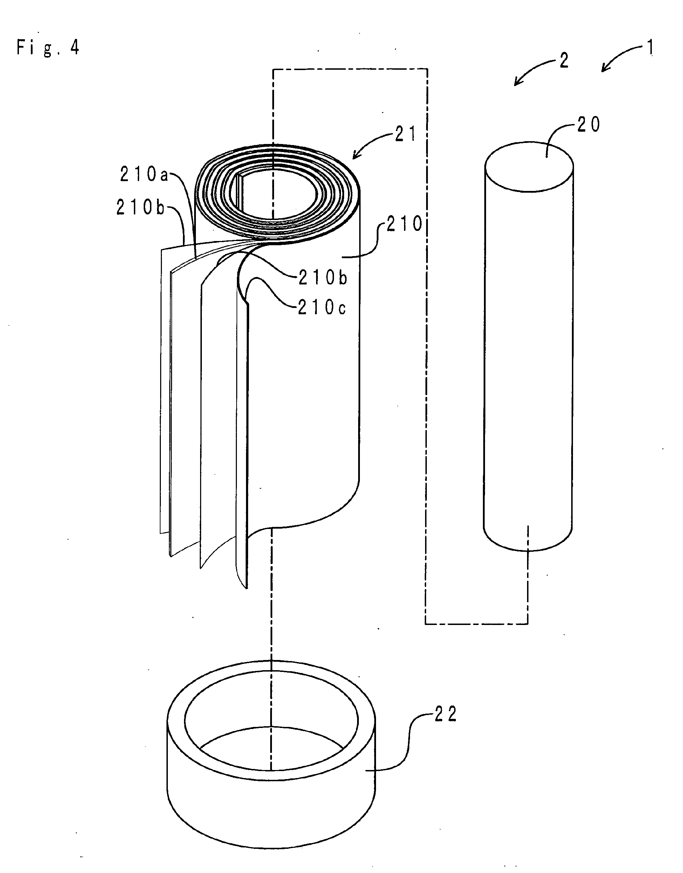

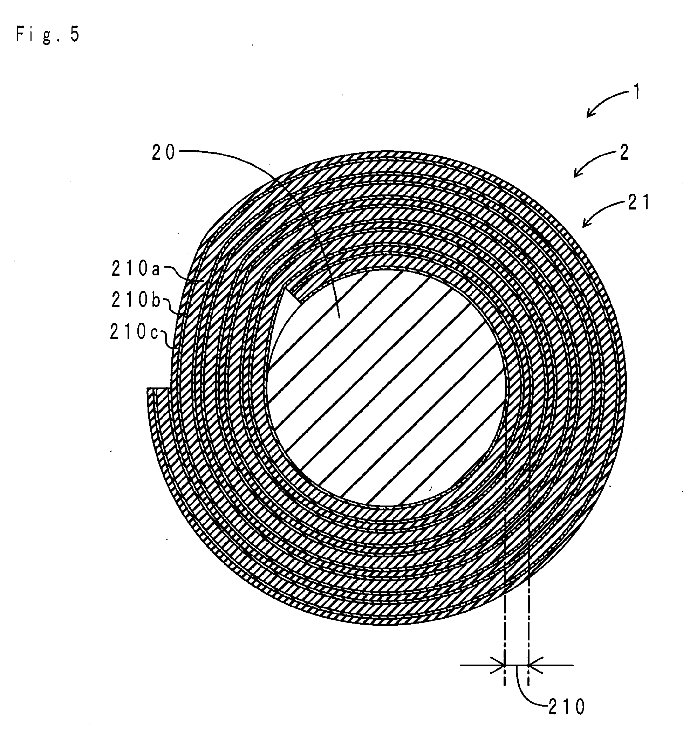

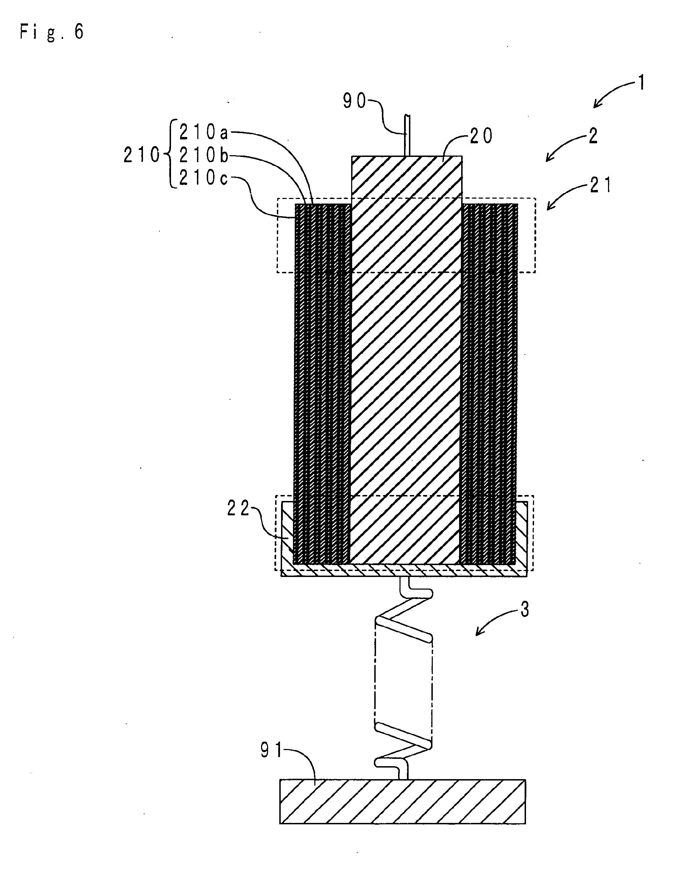

First, a constitution of the actuator of this embodiment is described below. Fig. 3 shows a perspective view of the actuator of this embodiment. Fig. 4 shows a perspective exploded view of the actuator element in the actuator. Fig. 5 shows an axially-perpendicular sectional view of the actuator. Fig. 6 shows an axially sectional view of the actuator. As shown in Figs. 3 to 6, the actuator 1 of this embodiment has an actuator element 2 and a coil spring 3. The coil spring 3 is included in an elastic member (a load member) of the present invention.

The actuator element 2 has a core material 20, a spiral tube member 21 and a base member 22. The axially-perpendicular diameter of the actuator element 2 is about 5 mm. The core material 20 is made of an elastomer and is formed of a round rod shape. The upper-end of the core material 20 is fixed via a wire material 90 to an upper member (not shown).

The spiral tube member 21 is annularly installed around the core material 20. More specifically, the spiral tube member 21 is formed of a band-shaped extensible film 210 which is spirally wound on the outer periphery of the core material 20.

The extensible film 210 includes a dielectric film 210a, an electrode 210b and an insulation film 210c. The dielectric film 210a is made of acrylic rubber. The electrode 210b is comprised of an elastomer film (a mixed material) obtained by mixing conductive carbon and an elastomer. A pair of the electrodes 210b is arranged on both the surfaces of the dielectric film 210a. The electrodes 210b, as shown in the above-mentioned Fig. 1, are electrically connected to a power source and a switch. The insulation film 210c, which is made of acrylic rubber, is arranged on the outer-peripheral surface of the electrode 210b located on the radially outside of the pair of the electrodes 210b.

The extensible film 210, as shown in Fig. 5, is wound on the outer-peripheral surface of the core material 20 so as to provide substantially five layers thereof. As shown in the dotted-line box of Fig. 6, both the axial ends of the core material 20 are formed such that both the core material 20 and the inner most layer of the extensible film 210, and both the extensible films 210 adjacent radially to each other are mutually bonded with each other.

The base member 22, which is made of insulating resin, is formed of a cup-shape opening upward. The base member 22 covers the lower-end of the spiral tube member 21. The base member 22 is caulkedly fixed to the lower-end of the spiral tube member 21.

The coil spring 3, which is made of steel, is installed between the base member 22 and a lower member 91. The coil spring 3 applies a downward urging force to the actuator element 2.

### [Movement of actuator]

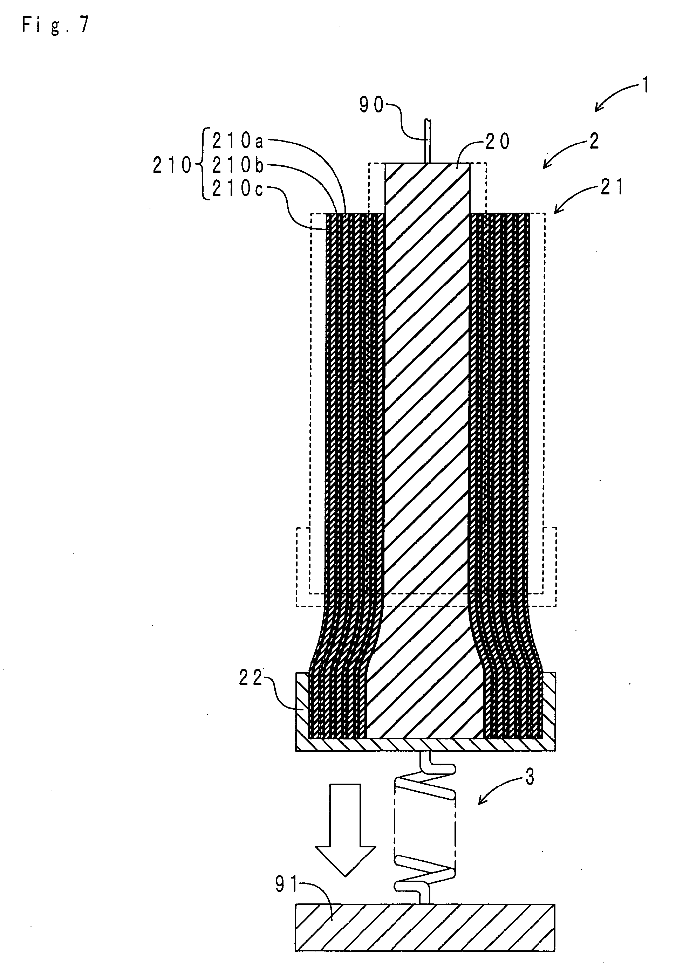

Then, a movement of the actuator 1 of this embodiment is described below. First, the movement thereof during voltage application will be explained. Fig. 7 shows an axially sectional view of the actuator 1 of this embodiment during voltage application. The dotted line in Fig. 7 shows the shape of the actuator element 2 before voltage application (see the above mentioned Fig. 6). In the state shown in the above-mentioned Fig. 6, when a voltage is applied across the pair of the electrodes 210b, the dielectric film 210a is compressed in the front-back (film thickness) direction. Hence, the film thickness of the dielectric film 210a becomes smaller. When the film thickness becomes small, to that extent, the area of the dielectric film 210a becomes wider. Thus, the dielectric film 210a extends together with the electrodes 210b and the insulation film 210c. That is, the spiral tube member 21 extends. Here, the base member 22 is fixed to the lower-end of the spiral tube member 21. Then, the coil spring 3 is connected to the base member 22. Hence, the actuator element 2 extends downward by the tension of the coil spring 3 as shown by the white-blanked arrow in Fig. 7.

Then, the movement thereof, when voltage is removed, will be explained. In the state shown in Fig. 7, when a voltage across the pair of the electrodes 210b is removed, the compression force acted in the front-back direction of the dielectric film 210a is removed. Hence, the film thickness of the dielectric film 210a becomes larger. When the film thickness becomes larger, to that extent, the area of the dielectric film becomes narrower. Thus, the dielectric film 210a contracts together with the electrodes 210b and the insulation film 210c. That is, the spiral tube member 21 contracts. Here, an elastic restoring force due to the pulling by the coil spring 3 is accumulated in the core material 20. Hence, the core material 20 also contracts due to the elastic restoring force. The actuator 1 stops in a state in which the contraction force of the upward acting core material 20 and spiral tube member 21 is balanced with the tension of the downward acting coil spring 3. That is, the actuator 1 is returned into the state as shown in the above-mentioned Fig. 6.

As explained above, the actuator 1 of this embodiment is switched from the state of Fig. 6 to the state of Fig. 7 due to voltage application. That is, it extends. And, it is switched from the state of Fig. 7 to the state of Fig. 6 due to voltage removal. That is, it contracts. In this way, the extension/contraction allows, for example, an object member (not shown) connected to the base member 22 to be driven.

### [Action and Effect]

Then, an action and an effect of the actuator of this embodiment will be explained. According to the actuator 1, with the coil spring 3, the extension/contraction direction of the actuator element 2 (the extensible film 210) is restricted axially. Hence, the axial displacement is large. Also, a stable movement becomes possible regardless of the attitude of the actuator 1. Also, the dielectric film 210a deforms integrally with the electrodes 210b and the insulation film 210c. Hence, the deformation of the dielectric film 210a is hardly to be hindered by the electrodes 210b and the insulation film 210c. Thus, a desired displacement is easily obtained, and the reduction of the driving force is small.

Also, using the coil spring 3 as a load member allows the actuator 1 to be constructed easily and at a low cost. Also, the base member 22 is arranged onto the axial lower-end of the actuator element 2. Hence, it is easy to connect the actuator element 2 and the coil spring 3 to each other. That is, the resultant force of the core material 20 and the spiral tube member 21 can be reliably transmitted to the coil spring 3.

Also, the core material 20 is arranged onto the axis portion, so that the shape of the actuator element 2 is easy to be kept. Here, the core material 20 is made of an elastomer. Hence, with the actuator 1, a flexible movement is possible. Also, the core material 20 is hardly changed in volume even if elastically deformed. In other words, when extended axially; the diameter is smaller, while when contracted, the diameter is larger. Hence, in the actuator 1, at extension/contraction, the core material 20 interferes hardly with the spiral tube member 21. In addition, the core material 20 is formed of a round rod shape. In other words, the side peripheral surface of the core material 20 is continuous axially. Thus, when compressed, the spiral tube member 21 cannot be caught by the core material 20.

Also, the spiral tube member 21 can be easily manufactured by winding the extensible film 210 around the core material 20. Hence, the actuator element 2 can be easily manufactured. Also, the extensible film 210 is wound, so that the actuator 1 can be configured compactly. Also, only applying/removing the voltage to the pair of the electrodes 210b allows the extensible film 210 to be extended/contracted, so that an electric wiring is easily placed. Also, the axially-perpendicular diameter of the actuator element 2 is as small as about 5 mm. Hence, the actuator 1 is suitable, for example, as an artificial muscle.

Also, in the wound extensible film 210, the insulation film 210c is arranged on the outer-peripheral surface of the electrodes 210b located radial outside. Hence, the adjacent electrodes 210b do not contact with each other. Thus, continuity between the adjacent electrodes 210b can be prevented.

### <Second embodiment>

The difference between the actuator of this embodiment and the actuator of the first embodiment is that in the actuator of this embodiment, a laminated tube member is arranged in place of the spiral tube member. Thus, only the difference will be explained here.

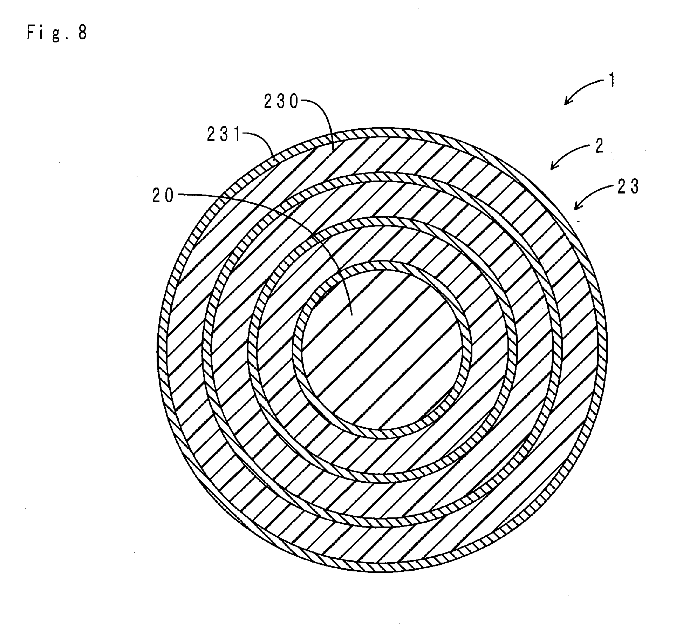

Fig. 8 shows an axially-perpendicular sectional view of the actuator of this embodiment. Further, the parts corresponding to those in Fig. 5 are indicated by the same symbols. As shown in Fig. 8, the actuator element 2 of the actuator 1 of this embodiment has laminated tube member 23. The laminated tube member 23 is annularly installed around the core material 20.

The laminated tube member 23 is formed such that three-layer dielectric films 230 and four-layer electrodes 231 are alternately laminated concentrically as if a tree ring. That is, a pair of the electrodes 231 is arranged on both the radial sides of any dielectric film 230.

The actuator 1 of this embodiment can be manufactured by dipping the core material 20 alternately into an electrode material solution for forming the electrode 231, and into a dielectric material solution for forming the dielectric film 230. Or, the actuator 1 may be manufactured by spraying alternately the electrode material solution and the dielectric material solution onto the core material 20. Also, the actuator 1 may be manufactured by sequentially or simultaneously extrusion molding the core material 20, the dielectric film 230 and the electrode 231.

The actuator 1 of this embodiment has an action and an effect similar to the first embodiment with respect to parts having a common construction. The actuator 1 of this embodiment has the laminated tube member 23. In the laminated tube member 23, each dielectric film 230 is laminated concentrically. Hence, applying a voltage across the electrodes 231 allows all of the dielectric films 230 held between electrodes 231 to be extended. Hence, the driving force and the displacement can be generated more efficiently.

### <Third embodiment>

The difference between the actuator of this embodiment and the actuator of the second embodiment is that no core material is arranged. Thus, only the difference will be explained here.

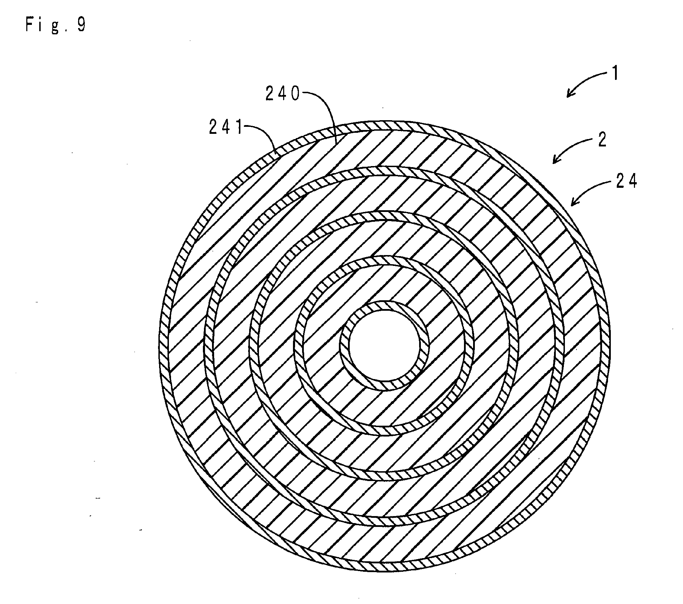

Fig. 9 shows an axially-perpendicular sectional view of the actuator of this embodiment. Further, the parts corresponding to those in Fig. 8 are indicated by the same symbols. As shown in Fig. 9, the actuator element 2 of the actuator 1 of this embodiment has laminated extensible member 24. The laminated extensible member 24 is formed such that three-layer dielectric films 240 and four-layer electrodes 241 are alternately laminated concentrically as if a tree ring. That is, a pair of the electrodes 241 is arranged on both the radial sides of any dielectric film 240.

The actuator 1 of this embodiment can be manufactured by drawing the core material 20 (see the above-mentioned Fig. 8) after manufacturing the actuator of the above-mentioned second embodiment. Also, it can be manufactured by sequentially or simultaneously extrusion molding the dielectric film 240 and the electrodes 241.

The actuator 1 of this embodiment has an action and an effect similar to the actuator of the second embodiment with respect to parts having common construction. Also, the actuator 1 of this embodiment, which has no core material, is easy to make the size thereof smaller and requires fewer numbers of parts.

### <Fourth embodiment>

The difference between the actuator of this embodiment and the actuator of the first embodiment is that in the actuator of this embodiment, another actuator element is arranged in place of the coil spring. Thus, only the difference will be explained here.

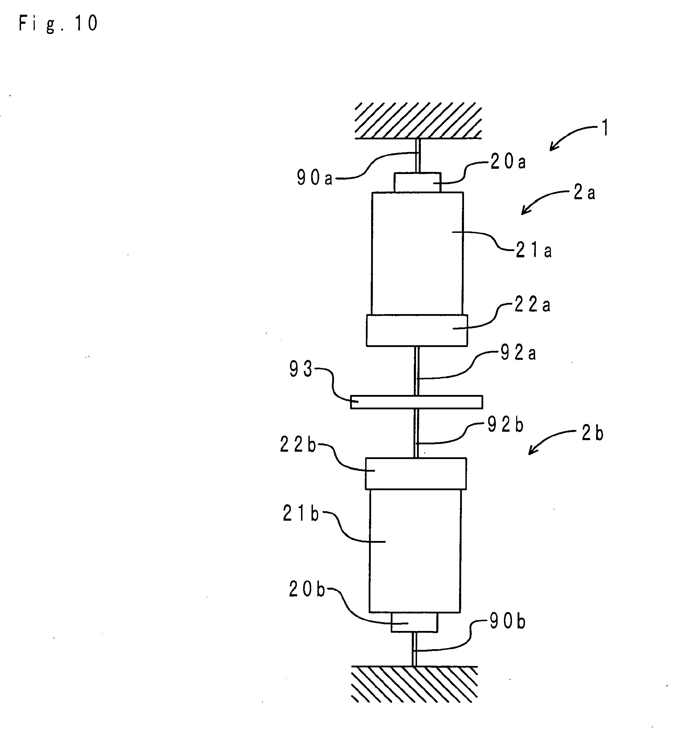

Fig, 10 shows a side view of the actuator of this embodiment. As shown in Fig. 10, the actuator 1 of this embodiment has two actuator elements 2a, 2b. The actuator element 2a has a core material 20a, a spiral tube member 21a and a base member 22a. The core material 20a is fixed via a wire material 90a to an upper wall portion. The base member 22a is fixed via a wire material 92a to an output rod 93. The actuator element 2b is arranged such that the actuator element 2b is exactly and vertically opposed to the actuator element 2a with the output rod 93 as a border line.

That is, the actuator element 2b has a core material 20b, a spiral tube member 21b and a base member 22b. The core material 20b is fixed via a wire material 90b to a lower wall portion. The base member 22b is fixed via a wire material 92b to an output rod 93. A predetermined tension is applied vertically to these actuator elements 2a, 2b.

For example, applying a voltage to the spiral tube member 21a of the actuator 2a causes the spiral tube member 21a to extend, whereby the output rod 93 is pulled by the tension of the actuator element 2b and thus moved downward. Conversely, applying a voltage to the spiral tube member 21b of the actuator element 2b causes the spiral tube member 21b to extend, whereby the output rod 93 is pulled by the tension of the actuator element 2a and thus moved upward. Thus, an object member (not shown) connected to the output rod 93 can be driven.

The actuator 1 of this embodiment has an action and an effect similar to the actuator of the first embodiment with respect to parts having common construction. Also, according to the actuator 1 of this embodiment, the output rod 93 can be vertically moved taking a state in which no voltage is applied as a reference position.

### <Fifth embodiment>

The difference between the actuator of this embodiment and the actuator of the fourth embodiment is that two actuator elements are arranged under the output rod. Thus, only the difference will be explained here.

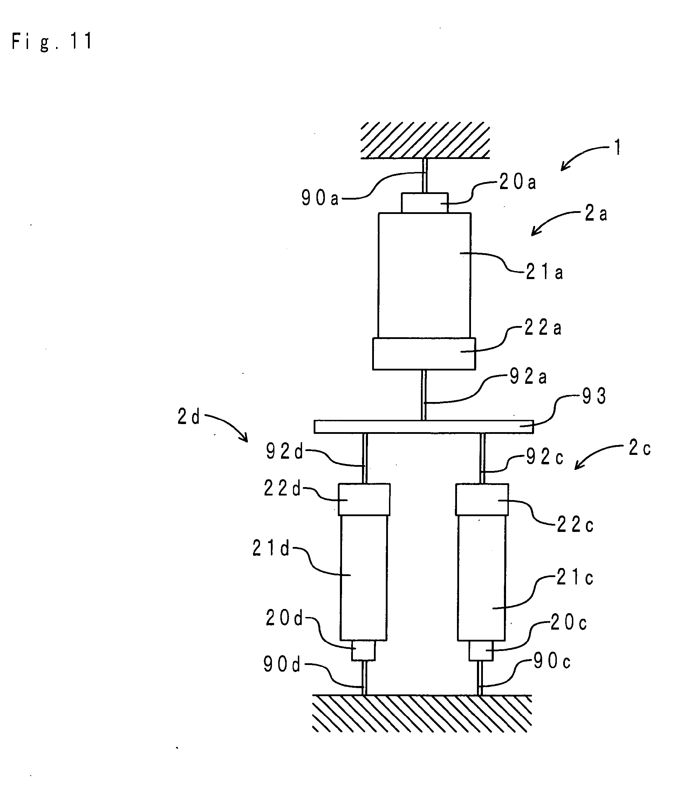

Fig. 11 shows a side view of the actuator of this embodiment. Further, the parts corresponding to those in Fig.10 are indicated by the same symbols. As shown in Fig. 11, the actuator 1 of this embodiment has two actuator elements 2c, 2d under the output rod 93. The actuator element 2c has a core material 20c, a spiral tube member 21c and a base member 22c. The core material 20c is fixed via a wire material 90c to a lower wall portion. The base member 22c is fixed via a wire material 92c to an output rod 93.

Similarly, the actuator element 2d has a core material 20d, a spiral tube member 21d and a base member 22d. The core material 20d is fixed via a wire material 90d to a lower wall portion. The base member 22d is fixed via a wire material 92d to an output rod 93. That is, the actuator elements 2c, 2d are arranged in parallel. A predetermined tension is applied to these actuator elements 2a, 2c and 2d. The spiral tube member 21c of the actuator element 2c and the spiral tube member 21d of the actuator element 2d have a smaller diameter than that of the spiral tube member 21a of the actuator element 2a.

For example, applying a voltage to the spiral tube member 21a of the actuator 2a causes the spiral tube member 21a to extend, whereby the output rod 93 is pulled by the tension of the actuator elements 2c, 2d and thus moved downward. Conversely, applying a voltage to the spiral tube member 21c, 21d of the actuator elements 2c, 2d causes the spiral tube member 21c, 21d to extend, whereby the output rod 93 is pulled by the tension of the actuator element 2a and thus moved upward. Thus, an object member (not shown) connected to the output rod 93 can be driven.

The actuator 1 of this embodiment has an action and an effect similar to the actuator of the first embodiment with respect to parts having common construction. Also, according to the actuator 1 of this embodiment, the output rod 93 can be vertically moved taking a state in which no voltage is applied as a reference position. Also, according to the actuator 1 of this embodiment, the object member can be driven by combining the plural types of actuator elements 2a, 2c and 2d.

### <Sixth embodiment>

The difference between the actuator of this embodiment and the actuator of the fourth embodiment is that two actuator elements are connected via a pulley to each other. Thus, only the difference will be explained here.

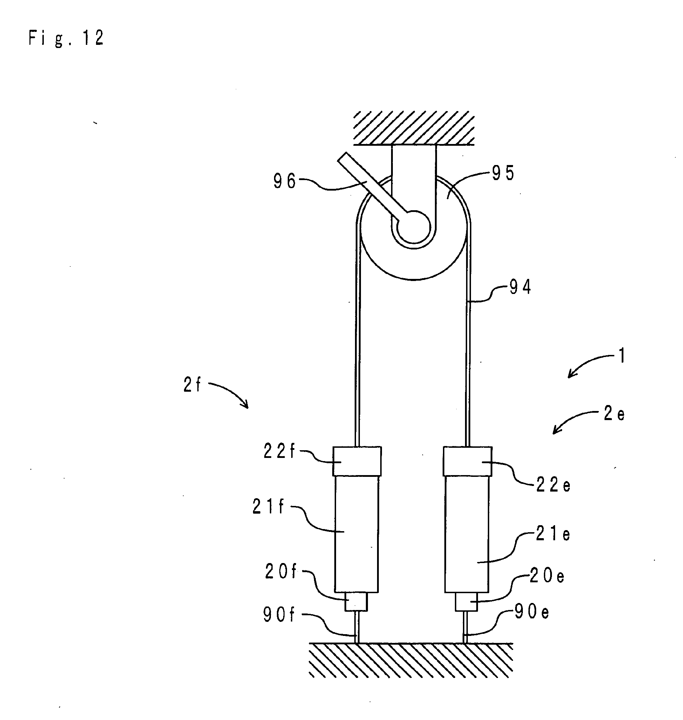

Fig. 12 shows a side view of the actuator of this embodiment. Further, the parts corresponding to those in Fig.10 are indicated by the same symbols. As shown in Fig. 12, the actuator 1 of this embodiment has two actuator elements 2e, 2f. The actuator element 2e has a core material 20e, a spiral tube member 21e and a base member 22e. The core material 20e is fixed via a wire material 90e to a lower wall portion.

The actuator element 2f has a core material 20f, a spiral tube member 21f and a base member 22f. The core material 20f is fixed via a wire material 90f to a lower wall portion.

The base member 22e of the actuator element 2e and the base member 22f of the actuator element 2f are connected via a wire material 94 to each other. The wire material 94 is wound on a pulley 95 hung from the upper wall portion. The rotating shaft of the pulley 95 is connected with an output arm 96.

For example, applying a voltage to the spiral tube member 21e of the actuator element 2e causes the spiral tube member 21e to extend, whereby the pulley 95 is pulled by the tension of the actuator elements 2f and thus pivoted counterclockwise in Fig. 12. Thus, the output arm 96 is also pivoted counterclockwise.

Conversely, applying a voltage to the spiral tube member 21f of the actuator element 2f causes the spiral tube member 21f to extend, whereby the pulley 95 is pulled by the tension of the actuator elements 2e and thus pivoted clockwise in Fig. 12. Thus, the output arm 96 is also pivoted clockwise. Thus, an object member (not shown) connected to the output arm 96 can be driven.

The actuator 1 of this embodiment has an action and an effect similar to the actuator of the first embodiment with respect to parts having common construction. Also, according to the actuator 1 of this embodiment, a driving force can be taken in the rotating direction rather than linear direction. Also, according to the actuator 1 of this embodiment, the output arm 96 can be pivoted in both the forward and backward directions taking a state in which no voltage is applied as a reference position.

### <Seventh embodiment>

The difference between the actuator of this embodiment and the actuator of the third embodiment is that a relatively large space is established in the axis portion. Thus, only the difference will be mainly explained here.

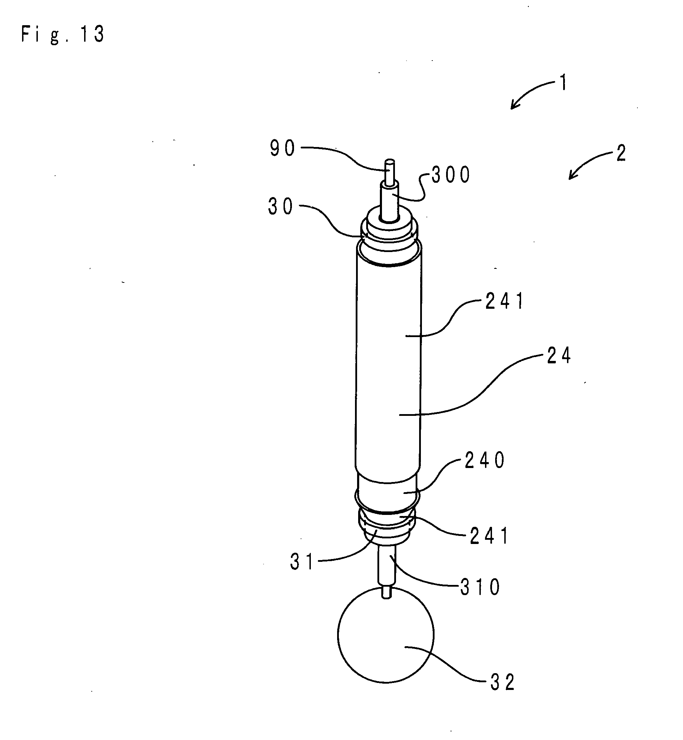

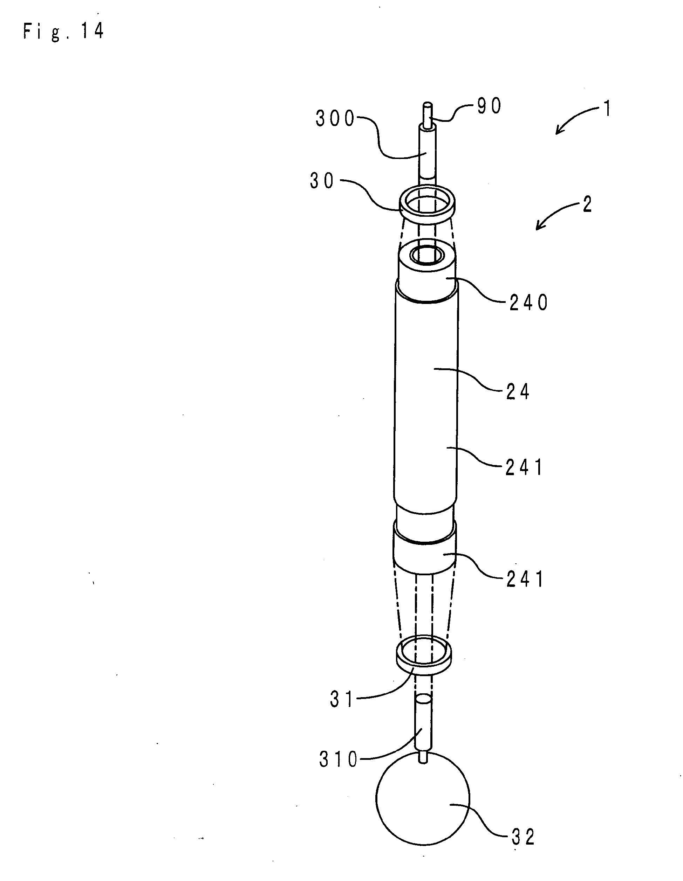

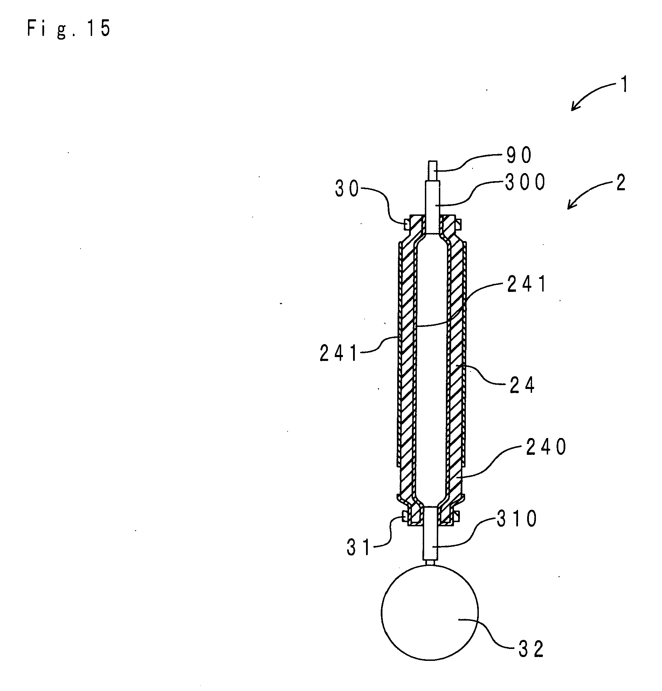

Fig. 13 shows a perspective view of the actuator of this embodiment. Fig. 14 shows a perspective exploded view of the actuator. Fig. 15 shows an axially sectional view of the actuator. Further, in Figs. 13 to 15, the parts corresponding to those in Fig. 9 are indicated by the same symbols. As shown in Figs. 13 to 15, the actuator 1 has the actuator element 2 and a weight 32.

The actuator element 2 has a laminated extensible member 24, an upper-side band 30, a lower-side band 31, an upper-side plug member 300 and a lower-side plug member 310.

The upper-side plug member 300, which is made of an insulating resin, is formed of a short-axis cylindrical shape. The upper-side plug member 300 is inserted into the inner-peripheral side of the upper-end opening of a later-described hollow cylindrical shaped (tube shaped) laminated extensible member 24. The upper-side band 30, which is made of an insulating resin, is formed of a ring shape. The upper-side band 30 is annularly installed around the upper-end outer-peripheral surface of the laminated extensible member 24. To explain in detail, the upper-side band 30 is fastened onto the upper-end outer-peripheral surface of the laminated extensible member 24 into which the upper-side plug member 300 is inserted. The upper-side plug member 300 is fixed via the wire material 90 to an upper member (not shown).

The lower-side plug member 310, which is made of an insulating resin, is formed of a short-axis cylindrical shape. The lower-side plug member 310 is inserted into the inner-peripheral side of the lower-end opening of the laminated extensible member 24. The lower-side band 31; which is made of an insulating resin, is formed of a ring shape. The lower-side band 31 is annularly installed around the lower-end outer-peripheral surface of the laminated extensible member 24. To explain in detail, the lower-side band 31 is fastened onto the lower-end outer-peripheral surface of the laminated extensible member 24 into which the lower-side plug member 310 is inserted. The weight 32 is hung from the lower-side plug member 310. The weight 32 applies a downward urging force to the actuator element 2.

The laminated extensible member 24 has a dielectric film 240 and a pair of electrodes 241. The dielectric film 240 is formed of a hollow cylindrical shape (tube shape). The pair of electrodes 241 is arranged on the inner-peripheral surface and outer-peripheral surface of the dielectric film 240. More specifically, the electrode 241, which is obtained by solidifying a mixture in which conductive carbon is mixed into two-liquid mixing-type silicone paste, is coated on the inner-peripheral surface and outer-peripheral surface of the dielectric film 240. Each of the pair of the electrodes 241 is connected to a power source (not shown).

Of the pair of the electrodes 241, the electrode 241 arranged on the inner-peripheral side of the dielectric film 240 covers all of the inner-peripheral surface of the dielectric film 240. Also, the electrode 241 is extendedly provided from the lower-end of the inner-peripheral surface of the dielectric film 240 via the lower-end surface to the lower-end of the outer-peripheral surface thereof.

On the other hand, of the pair of the electrodes 241, the electrode 241 arranged on the outer-peripheral side of the dielectric film 240 covers the intermediate portion of the outer-peripheral surface of the dielectric film 240. That is, at the upper-end of the dielectric film 240, the electrode 241 on the outer-peripheral side is arranged away by a predetermined distance from the upper-side band 30. And, at the lower-end of the dielectric film 240, the electrode 241 on the outer-peripheral side is arranged away by a predetermined distance from the electrode 241 connected to the inner-peripheral side.

The actuator 1 of this embodiment has an action and an effect similar to the actuator of the third embodiment with respect to parts having common construction. Also, according to the actuator 1 of this embodiment, a space is established in the axis portion. Hence, for example, compared with the actuator of the type having the core material 20 as shown in the above-mentioned Fig. 8, when drivingly deformed, the electrode 241 on the inner-peripheral side is not restrained. Also, the actuator 1 becomes lighter in weight to an extent that a space is established in the axis portion. Also, when an external shock is applied, the actuator element 2 is easily deformed to an extent that a space is established in the axis portion. Hence, it is easy to absorb the shock. Also, according to the actuator 1 of this embodiment, the electrode 241 arranged on the inner-peripheral side of the dielectric film 240 is extendedly provided from the lower-end of the inner-peripheral surface of the dielectric film 240 via the lower-end surface to the lower-end of the outer-peripheral surface thereof. Hence, it is easy to connect with the power source.

### <Eighth embodiment>

The difference between the actuator of this embodiment and the actuator of the seventh embodiment is that the electrode on the inner-peripheral side is pasty (not solidified). Thus, only the difference will be mainly explained here.

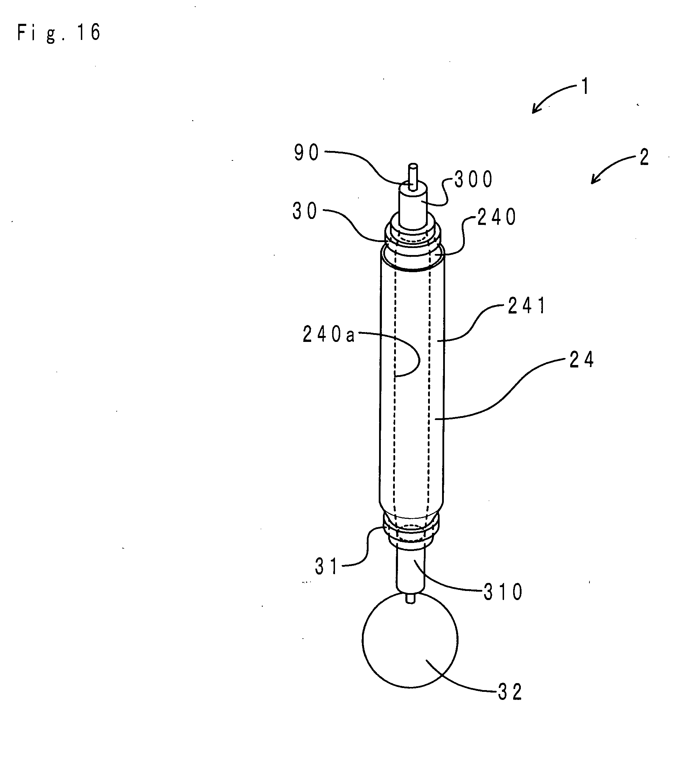

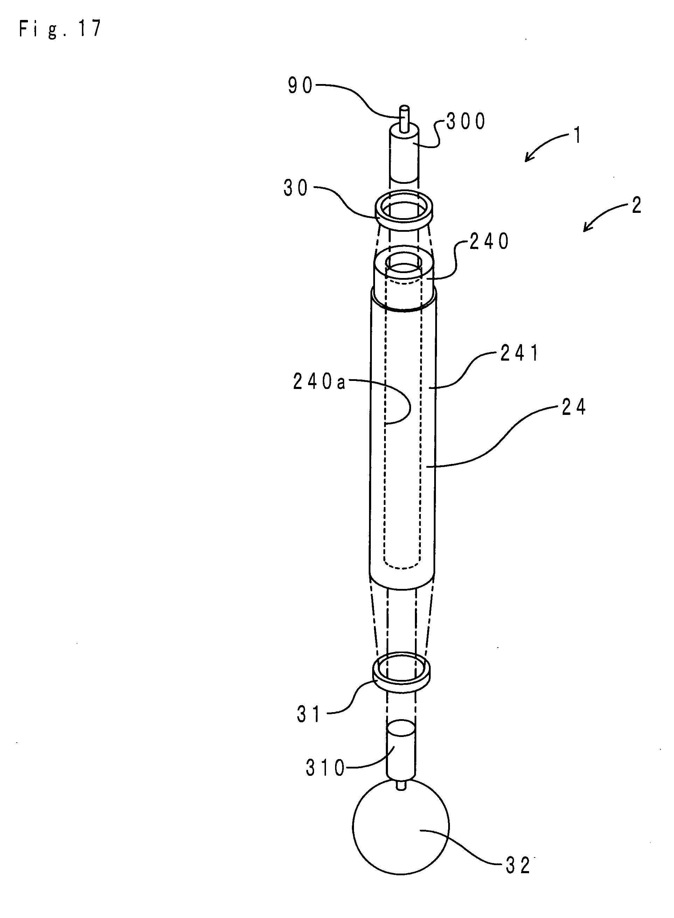

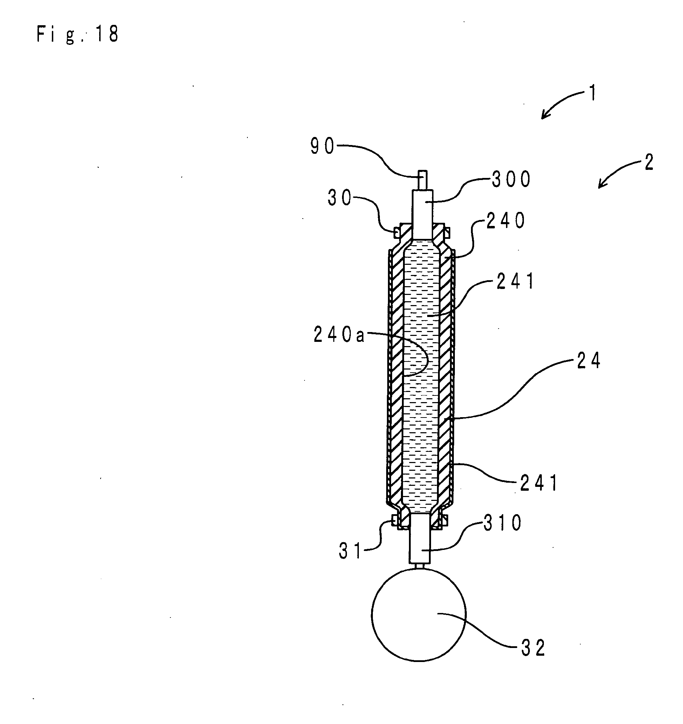

Fig. 16 shows a perspective view of the actuator of this embodiment. Fig. 17 shows a perspective exploded view of the actuator. Fig. 18 shows an axially sectional view of the actuator. Further, in Figs. 16 to 18, the parts corresponding to those in Figs. 13 to 15 are indicated by the same symbols.

As shown in Figs. 16 to 18, the actuator element 2 has a laminated extensible member 24, an upper-side band 30, a lower-side band 31, an upper-side plug member 300 and a lower-side plug member 310.

The laminated extensible member 24 has a dielectric film 240 and a pair of electrodes 241. The dielectric film 240 is formed of a hollow cylindrical shape (tube shape). That is, the dielectric film 240 has an accommodating portion 240a. The upper-end opening of the accommodating portion 240a is sealed by the upper-side plug member 300. The lower-end opening of the accommodating portion 240a is sealed by the lower-side plug member 310. The electrode 241 on the inner-peripheral side, which is a paste obtained by mixing conductive carbon with a silicone oil, is poured into the accommodating portion 240a. A thin-plate shaped terminal (not shown) is immersed in the electrode 241 of the accommodating portion 240a. The terminal penetrates the upper-side band 30 and is connected to a power source (not shown). The electrode 241 on the outer-peripheral side is extendedly provided from the outer-peripheral surface of the dielectric film 240 to the lower-end surface thereof.

The actuator 1 of this embodiment has an action and an effect similar to the actuator of the seventh embodiment with respect to parts having common construction. Also, according to the actuator 1 of this embodiment, the electrode 241 on the inner-peripheral side is pasty. Hence, for example, compared with the actuator of the type having the core material 20 as shown in the above-mentioned Fig. 8, when drivingly deformed, the electrode 241 on the inner-peripheral side is not restrained. Also, when an external shock is applied, the electrode 241 deforms or fluidizes, whereby the shock is easy to be absorbed.

### <Ninth embodiment>

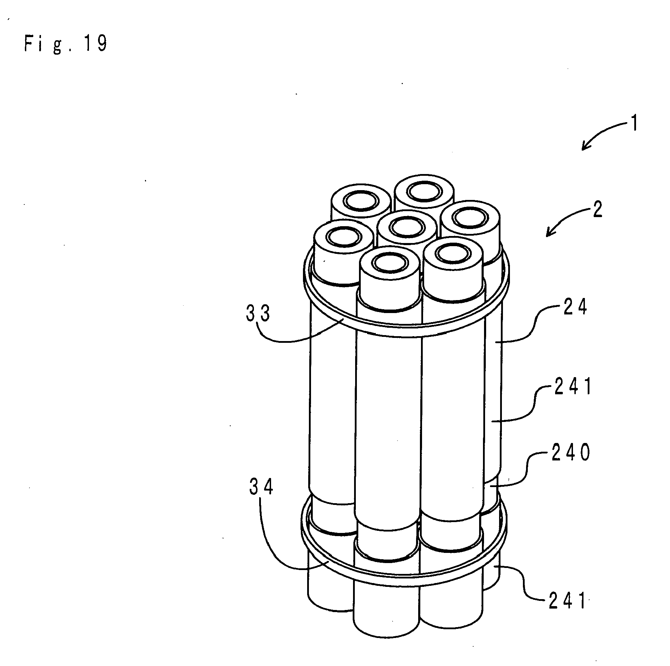

The actuator of this embodiment is formed by binding seven actuator elements of the seventh embodiment. Fig. 19 shows a partially perspective view of the actuator of this embodiment. Further, the parts corresponding to those in Figs. 13 are indicated by the same symbols.

As shown in Fig. 19, the actuator 1 of this embodiment has total seven actuator elements 2. The actuator elements 2 are bound circularly by an upper-side clamp 33 and a lower-side clamp 34.

The upper-side clamp 33, which is made of a metal, is pressed on the electrodes 241 on the outer-peripheral side of each of the seven actuator elements 2. These seven electrodes 241 are connected by the upper-side clamp 33. The upper-side clamp 33 is connected to a power source (not shown). That is, the upper-side clamp 33 functions as a common terminal of the electrodes 241 on the outer-peripheral side.

On the other hand, the lower-side clamp 34, which is made of a metal, is pressed on the electrodes 241 (which is in detail the electrode 241 extendedly provided from the inner-peripheral surface of the dielectric film 240 via the lower-end surface to the lower end of the outer-peripheral surface thereof) on the inner-peripheral side of each of the seven actuator elements 2. These seven electrodes 241 are connected by the lower-side clamp 34. The lower-side clamp 34 is connected to a power source (not shown). That is, the lower-side clamp 34 functions as a common terminal of the electrodes 241 on the inner-peripheral side.

A commonly-used upper-side plug member (not shown) for sealing the upper-end openings of all of the seven laminated extensible member 24 is arranged on the upper portion of the upper-side clamp 33 of the bound actuator element 2. With the upper-side plug member, the actuator 1 is fixed to an upper member (not shown). Also, the upper-end opening inserting portion of the upper-side plug member and the upper-side clamp 33 are opposed to each other radially.

On the other hand, a commonly-used lower-side plug member (not shown) for sealing the lower-end openings of all of the seven laminated extensible member 24 is arranged on the lower portion of the lower-side clamp 34 of the bound actuator element 2. The lower-end opening inserting portion of the lower-side plug member and the lower-side clamp 34 are opposed to each other radially. A weight (not shown) is hung from the lower-side plug member.

The actuator 1 of this embodiment has an action and an effect similar to the actuator of the seventh embodiment with respect to parts having common construction. Also, according to the actuator 1 of this embodiment, the actuator elements 2 are connected in parallel to each other. Hence, a larger driving force can be outputted.

Also, according to the actuator 1 of this embodiment, each of the upper-side clamp 33 and the lower-side clamp 34 functions as a commonly-used terminal. Hence, compared to a case where the electrodes 241 are individually connected to the power source, the wiring becomes simpler. Also, compared to a case where the member for binding the actuator elements 2 and the commonly-used terminal are separately arranged, the number of the parts becomes fewer.

### <Tenth embodiment>

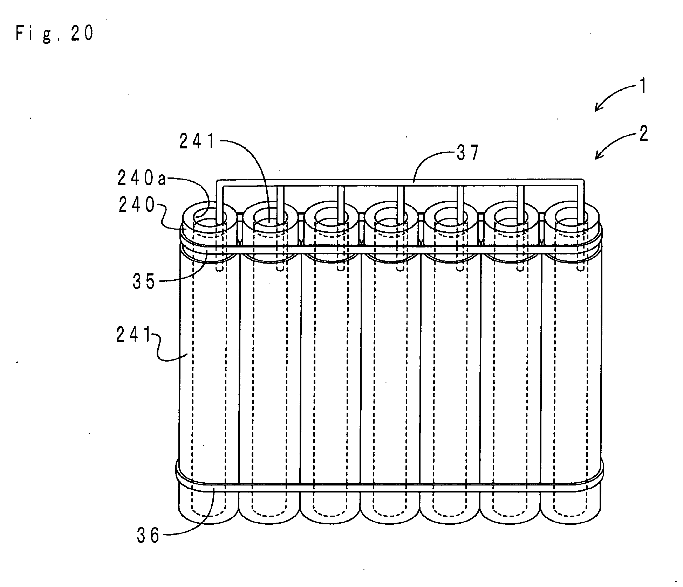

The actuator of this embodiment is formed by binding seven actuator elements of the eighth embodiment. Fig. 20 shows a partially perspective view of the actuator of this embodiment. Further, the parts corresponding to those in Figs. 16 are indicated by the same symbols.

As shown in Fig. 20, the actuator 1 of this embodiment has total seven actuator elements 2. The actuator elements 2 are bound linearly by an upper-side clamp 35 and a lower-side clamp 36. A comb-shaped commonly-used terminal 37, which is made of a metal, is immersed in the accommodating portion 240a of the seven dielectric films 240. The commonly-used terminal 37 is connected to a power source (not shown).

A commonly-used upper-side plug member (not shown) for sealing the upper-end openings of all of the seven dielectric films 240 is arranged on the upper portion of the upper-side clamp 35 of the bound actuator elements 2. With the upper-side plug member, the actuator 1 is fixed to an upper member (not shown). Also, the upper-end opening inserting portion of the upper-side plug member and the upper-side clamp 35 are opposed to each other radially.

On the other hand, a commonly-used lower-side plug member (not shown) for sealing the lower-end openings of all of the seven dielectric films 240 and electrodes 241 is arranged on the lower portion of the lower-side clamp 36 of the bound actuator element 2. The lower-end opening inserting portion of the lower-side plug member and the lower-side clamp 36 are opposed to each other radially. A weight (not shown) is hung from the lower-side plug member.

The actuator 1 of this embodiment has an action and an effect similar to the actuator of the eighth embodiment with respect to parts having common construction. Also, according to the actuator 1 of this embodiment, the actuator elements 2 are connected in parallel to each other. Hence, a larger driving force can be outputted.

Also, according to the actuator 1 of this embodiment, the lower-side clamp 36 functions as a commonly-used terminal. Hence, the wiring becomes simpler. Also, compared to a case where the member for binding the actuator elements 2 and the commonly-used terminal are separately arranged, the number of the parts becomes fewer.

### <Eleventh embodiment>

The difference between the actuator of this embodiment and the actuator of the tenth embodiment is that not only the electrode on the inner-peripheral side but also the electrode on the outer-peripheral side is pasty (not solidified). Thus, only the difference will be explained here.

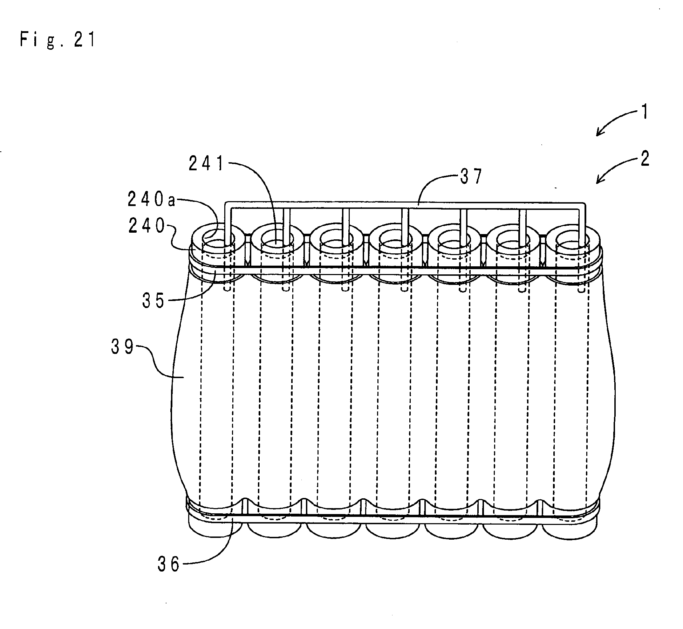

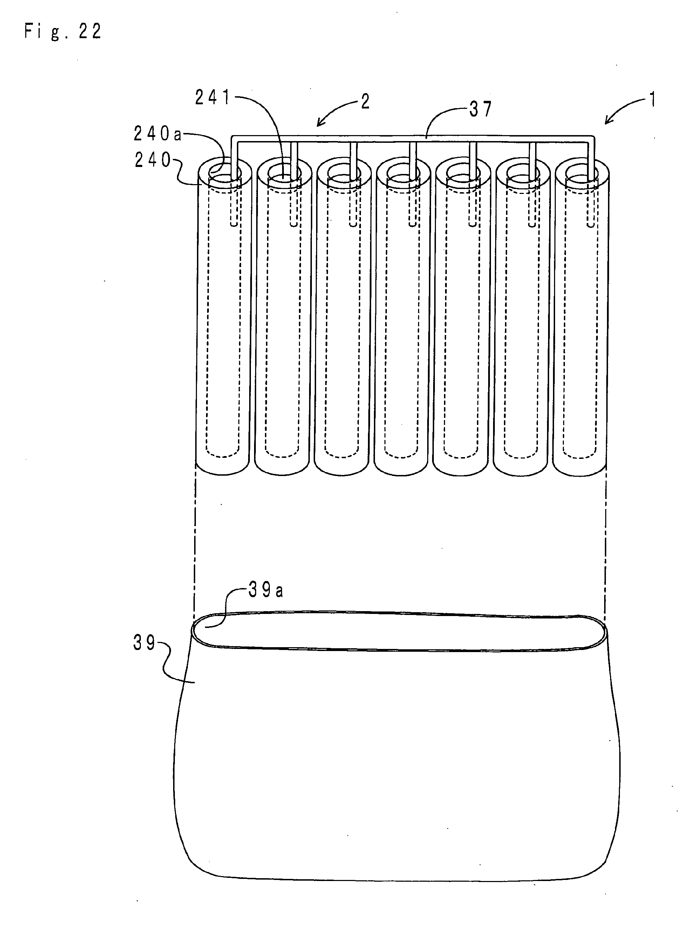

Fig. 21 shows a partially perspective view of the actuator of this embodiment. Fig. 22 shows a partially perspective exploded view of the actuator of this embodiment. Further, in Figs. 21, 22, the parts corresponding to those in Figs. 20 are indicated by the same symbols.

As shown in Figs. 21 and 22, the actuator 1 has a bag member 39. The bag member 39 is made of a soft resin and has an insulation property. The bag member 39 is formed of s a tube shape capable of accommodating the seven actuator elements 2. The bag member 39 covers the portion other than the upper/lower ends on the outer-peripheral surface of the seven dielectric films 240 from the outside diameter side. The upper/lower ends of the bag member 39 are jointed along the outer-peripheral surface profile to that outer-peripheral surface thereof. Hence, the upper/lower ends of the bag member 39 are liquid-tightly sealed. An accommodating portion 39a is divided inside the sealed bag member 39.

An electrode (not shown) is poured in the accommodating portion 39a. The electrode is a paste obtained by mixing conductive carbon with silicone oil. The electrode is in contact with the portion other than the upper/lower ends on the outer-peripheral surface of the seven dielectric films 240. A commonly-used thin-rod shaped terminal (not shown) penetrates the wall portion of the bag member 39 and is inserted into the electrode of the accommodating portion 39a. The commonly-used terminal is connected to a power source (not shown). The electrode 241 is poured in each of the accommodating portion 240a of the dielectric film 240 of the seven actuator elements 2.

The upper-end opening of the seven accommodating portion 240a is sealed by a commonly-used upper-end plug member (not shown), and the lower-end opening thereof is sealed by a commonly-used lower-end plug member (not shown), respectively. On the other hand, the upper-end of the seven dielectric films 240 is bound by an upper-side clamp (not shown), and the lower-end thereof is bound by a lower-end clamp (not shown), respectively. The upper-side plug member and the upper-side clamp are opposed to each other radially. And, the lower-side plug member and the lower-side clamp are opposed to each other radially. By the upper-side plug member, the actuator 1 is fixed to an upper member (not shown). Also, a weight (not shown) is hung from the lower-side plug member.

The actuator 1 of this embodiment has an action and an effect similar to the actuator of the tenth embodiment with respect to parts having common construction. Also, according to the actuator 1 of this embodiment, the electrode poured in the accommodating portion 39a of the bag member 39, that is, the electrode on the outer-peripheral side of the dielectric film 240 is pasty. Hence, when drivingly deformed, the electrode on the outer-peripheral side is not restrained. Also, fluidization and deformation of the electrode 241 on the outer-peripheral side and the inner-peripheral side allows an externally applied shock to be absorbed. Also, according to the actuator 1 of this embodiment, a terminal commonly-used by the seven actuator elements 2 is arranged. Hence, the wiring becomes simpler.

### <Others>

As mentioned above, embodiments of the actuator of the present invention has been explained. However, embodiments are not particularly limited to the above-mentioned embodiments. They can also be performed by various modifications and improvements made by the person skilled in the art.

For example, in the above-mentioned first and second embodiments, the solid round-rod shaped core material has been used. However, the shape, size and the like of the core material are not particularly to be limited. Also, for the shape of the core material, solid and hollow are not a matter. Also, the core material may be anything elastically-deformable in the axial direction. For example, as materials having substantially no volume change due to elastic deformation, there are suitable elastomers such as silicone rubber, acrylic rubber, ethylene-propylene-diene terpolymer (EPDM), ethylene-propylene rubber, natural rubber (NR), butyl rubber (IIR), isoprene rubber (IR), acrylonitrile-butadien copolymer rubber (NBR), hydrogenation acrylonitrile-butadien copolymer rubber (H-NBR), hydrin-type rubber, chloroprene rubber (CR), fluororubber, and urethane rubber. Further, an aspect having no core material such as the above-mentioned third embodiment may of course be used.

Also, in the above-mentioned embodiments, the dielectric film made of acrylic rubber has been used. However, a material of the dielectric film which is deformed in response to the electrostatically attractive force between a pair of both-side electrodes is not particularly limited. For example, as a dielectric elastomer having high dielectric properties and insulation breakdown strength, in addition to the above-mentioned acrylic rubber, there are shown silicone rubber, ethylene-propylene-diene terpolymer (EPDM), ethylene-propylene rubber, natural rubber (NR), butyl rubber (IIR), isoprene rubber (IR), acrylonitrile-butadien copolymer rubber (NBR), hydrogenation acrylonitrile-butadien copolymer rubber (H-NBR), hydrin-type rubber, chloroprene rubber (CR), fluororubber, and urethane rubber. Also, the shape and size of the dielectric film are not particularly limited and may be determined as required according to the applications of the actuator. For example, with respect to achieving of a smaller size, a lower potential driving and a larger displacement, a smaller thickness of the dielectric film is desirable. In this case, taking the insulation breakdown strength into consideration, the thickness of the dielectric film is preferably 1µm or more and 1000µm (1mm) or less. The thickness of 5µm or more and 200µm or less is more suitable.

Also, the material of the electrode, though not limited to the above-mentioned embodiments, preferably is extensible/contractible in response to the extension/contraction of the dielectric film. When the electrode extends/contracts together with the dielectric film, the deformation of the dielectric film is hardly hindered by the electrode, whereby a more desirable displacement is easily obtained. For example, it is preferable to form the electrode by coating a paste or a paint obtained by mixing oil or elastomer as a binder onto a conductive material consisting of a carbon material such as carbon black and carbon nanotube or of metallic material. As elastomers for binder, for example, there are suitable flexible material such as silicone rubber, acryl rubber, ethylene-propylene-diene terpolymer (EPDM), natural rubber (NR), butyl rubber (IIR), isoprene rubber (IR), acrylonitrile-butadien copolymer rubber (NBR), hydrogenation acrylonitrile-butadien copolymer rubber (H-NBR), hydrin-type rubber, chloroprene rubber (CR), fluororubber, and urethane rubber. Also, in order to improve the extension/contraction properties of the dielectric film, the electrode may be formed by directly bonding a conductive finely-divided substance, such as carbon black and carbon nanotube onto the surface of the dielectric film.

Also, in the above-mentioned first, fourth, fifth and sixth embodiments, the spiral tube member has been constructed by winding the extensible film having the insulation film. Here, a material of the insulation film which can prevent the continuity between adjacent electrodes is not particularly limited. For example, like the above-mentioned electrode, it is desirable to be extensible/contractible in response to the extension/contraction of the dielectric film. For example, there are suitable flexible material such as silicone rubber, acrylic rubber, ethylene-propylene-diene terpolymer (EPDM), natural rubber (NR), butyl rubber (IIR), isoprene rubber (IR), acrylonitrile-butadien copolymer rubber (NBR), hydrogenation-acrylonitrile-butadien copolymer rubber (H-NBR), hydrin-type rubber, chloroprene rubber (CR), fluororubber, and urethane rubber. Making the material of the insulation film equal to that of the dielectric film allows a larger driving force to be obtained.

Also, in the above-mentioned first, fourth, fifth and sixth embodiments, the insulation film has been arranged so as to cover all the surface of the electrode. However, if the continuity between adjacent electrodes is prevented, the insulation film may be arranged only on a part of the surface of the electrodes. Also, if the outer most layer of the spiral tube member is the insulation film made of a dielectric elastomer, the electrodes may additionally be arranged on that surface. In this way, even the insulation film on the outer most layer can be deformed similarly to the dielectric film, so that a larger driving force can be obtained.

Also, in the above-mentioned embodiments, the axially-perpendicular diameter of the actuator element has been made approx. 5 mm. However, the axially size and the axially-perpendicular size of the actuator element are not particularly limited. Also, as shown in the above-mentioned embodiments, the actuator elements may be used by connecting only one thereof to the load member, and may be used by connecting plural ones thereof bound to the load member. In this way, a larger driving force can be outputted. Particularly, for string-shaped actuator element or thin fibrous actuator element as shown in the above-mentioned embodiments, it is desirable to be used by binding plural ones thereof. The actuator thus constructed is useful, for example, as an artificial muscle. Also, plural actuator elements may be used by being knitted using stockinet and the like. Further, plural actuator elements may be used by knitting a collectively-bound portion obtained by binding plural ones thereof in the similar manner. Also, the number of radially-laminated dielectric films is not particularly limited. The more the number of laminated layers, the larger the driving force can be made.

Also, in the above-mentioned embodiments, at both the axial ends of the actuator element, the core material and the spiral tube member, or the core material and the laminated tube member, or respective ones of the spiral tube member, or the respective ones of the laminated tube member have been bonded to each other. However, these fixing places and the fixing methods are not particularly limited. Both the axial ends of the actuator element may be caulked to fix, and over the whole in the axial direction, the core material and the spiral tube member, or the core material and the laminated tube member may be bonded to each other. Also, in the above-mentioned first, fourth, fifth and sixth embodiments, the base member has been arranged on one axial end of the spiral tube member. However, the base member may be arranged on both the axial ends of the spiral tube member.

Although in the above-mentioned embodiments, the coil spring and the actuator element have been used as a load member, the kind of the load member is not particularly limited. For example, as an elastic member, other than the above-mentioned coil spring, spring members such as plate spring, volute spring, belleville spring and power spring, and rubber tube and the like are shown. Also, a weight may be hung.

Also, in the above-mentioned embodiments, the actuator has been actuated by switching from an off state (0V) to on state. However, the voltage before actuation is not always required to be 0 volt. For example, it may be actuated by making the applied voltage larger from a predetermined value.

Also, although in the sixth embodiment, the output arm has been pivoted by the pulley and the wire material, the output arm may be pivoted by, for example, sprocket and chain, and pulley and belt, and the like. In this way, the power transmission loss due to slippage is easily restrained. Also, although in the seventh and ninth embodiments, the solid electrode has been used, a gel-like or pasty electrode may be used.

Also, although in the ninth and tenth embodiments, the actuator has been fixed to the upper member by the upper-side plug member, the actuator may be fixed to the upper member by the upper-side clamp. Also, although in the ninth and tenth embodiments, the weight has been hung from the lower-side plug member, the weight may be hung from the lower-side clamp.

### EXAMPLES

Hereinafter, the experiment performed on the actuator of the present invention will be explained.

### [Samples of example]

The sample of the example 1 is an actuator having the same type as that of the actuator (see the above-mentioned Figs. 13 to 15) of the above-mentioned seventh embodiment. The dielectric film of the sample of the example 1 is made of silicone rubber. And, the electrode of the sample of the example 1 is made of paste obtained by mixing silicone oil with conductive carbon.

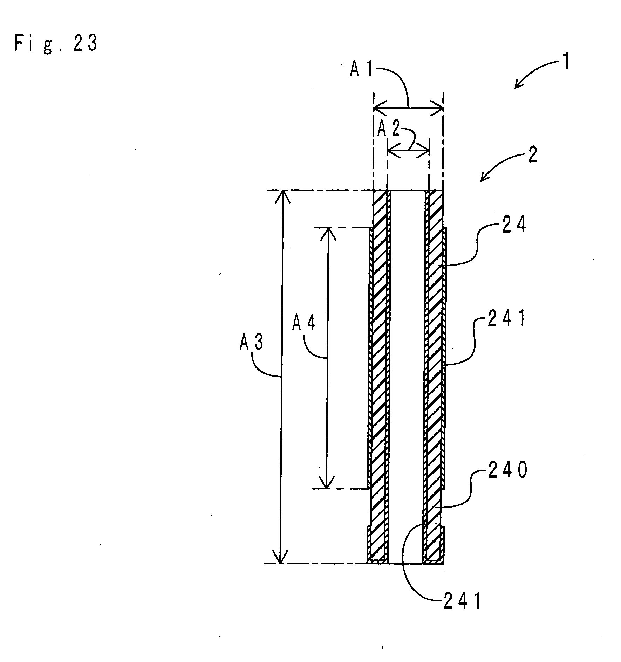

Fig. 23 shows a dimensional view of the laminated extensible member of the sample of the example 1. Further, the parts corresponding to those in Figs. 15 are indicated by the same symbols. The outer diameter A1 of the dielectric film 240 is 0.6 mm. The inner diameter A2 of the dielectric film 240 is 0.5 mm. The axial length A3 of the electrode 241 on the inner-peripheral side is 180 mm. The axial length A4 of the electrode 241 on the outer-peripheral side is 120 mm. As shown in the above-mentioned Fig. 15, the upper-side band 30 and the lower-side band 31 are attached onto the upper/lower ends of the laminated extensible member 24 having the above-mentioned dimensions.

The sample of the example 2 is an actuator having the same type as that of the actuator (see the above-mentioned Fig. 19) of the above-mentioned ninth embodiment. That is, the actuator is formed by attaching the upper-side plug member and the lower-side plug member onto the portion obtained by binding twenty laminated extensible member 24 of the sample of the example 1.

### [Sample of compared example]

The difference between the sample of compared example and the sample of example 1 is that the weight (see the above-mentioned Figs. 13 to 15) is not arranged. That is, it is that the member is not arranged which orients the deforming direction of the laminated extensible member to the axial direction. The sample of compared example has no weight (load member) and thus is not actuated by loosing the force balance.

### [Experimental method and results]

When a voltage was applied to the samples of example 1, example 2 and compared example, the axial displacement and the output and the behavior were examined. The mass of the weight 32 (see the above-mentioned Figs. 13 to 15) of the sample of example 1 was set at 1.4 g. The mass of the weight of the sample of example 2 was set at 14 g.

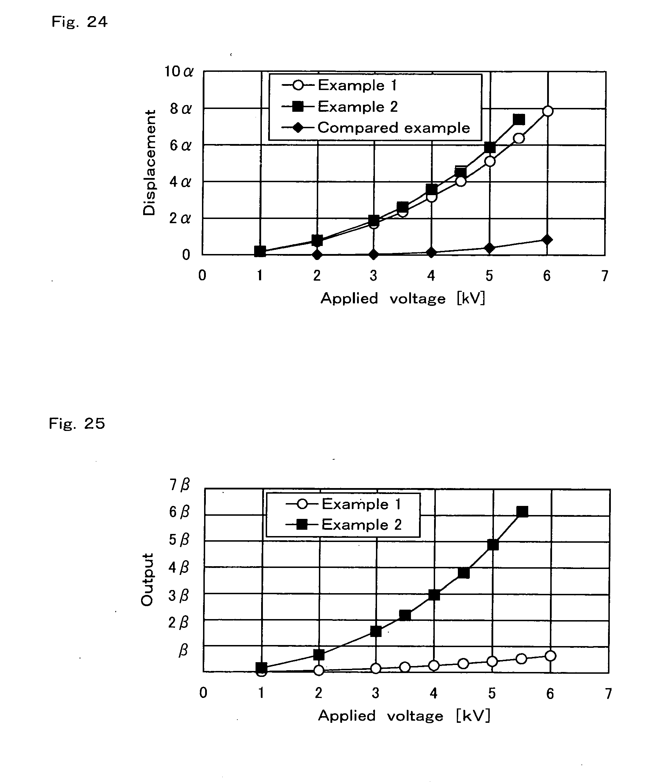

In Fig. 24, the relationship between applied voltage and displacement (axial displacement) is shown by graph. As shown in Fig. 24, it is understood that the displacement is more easily taken out by the samples of examples 1 and 2 than by the sample of compared example. Also, it is understood that the tendency becomes significant as the applied voltage becomes large. Also, it is understood that the sample obtained by binding twenty laminated extensible member 24 as for example 2, and the sample having one laminated extensible member 24 as for example 1 exhibit substantially the same displacement, and thus exhibit a larger displacement than compared example.

In Fig. 25, the relationship between applied voltage and output is shown by graph. As shown in Fig. 25, it is understood that the sample of example 2 exhibits a larger output than the sample of example 1. Also, it is understood that the tendency becomes significant as the applied voltage becomes large.

Further, where a load member such as the weight is not arranged as in compared example, when an uneven thickness of the dielectric film and the electrode occurs, often the sample does not displaces in the predetermined direction, while where a load member such as the weight is arranged as in examples 1 and 2, the displacement direction is set in the predetermined direction, thereby allowing a stable displacement to be realized.

The actuator of the present invention is useful, for example, to the artificial muscle for power-assist suit, and industrial, medical and welfare robots, to the miniature pump for electronics cooling and medical application, and to medical instruments and the like, and further, can be utilized as an alternative to all actuators such as mechanical actuator including motors and piezoelectric-element actuator and the like.

## Claims

1. An actuator comprising:
a rod-shaped actuator element, having one axial end thereof fixed, including a dielectric film made of a dielectric elastomer and a plurality of electrodes arranged via said dielectric film, in said actuator element, said dielectric film extends as a voltage applied across said electrodes becomes large; and
a load member connected to the other axial end of said actuator element and fixed in a state in which said actuator element is permitted to be extended axially; **characterized in that** making large the voltage applied across said electrodes causes said dielectric film to be extended, whereby said actuator element is extended axially according to the tension of said load member.

2. An actuator according to claim 1, wherein said load member is at least one of a weight and an elastic member.

3. An actuator according to claim 1, wherein said load member is said actuator element.

4. An actuator according to claim 1, wherein said actuator element has a spiral extensible member formed by winding spirally an extensible film which includes said dielectric film, a pair of said electrodes arranged on both the surfaces of said dielectric film, and an insulation film arranged on one of the surfaces of a pair of said electrodes.

5. An actuator according to claim 1, wherein said actuator element has a laminated extensible member formed by laminating alternately said dielectric film and said electrodes in concentric circular shape.

6. An actuator according to claim 5, wherein said laminated extensible member has a hollow cylindrical shape.

7. An actuator according to claim 1, wherein said actuator element has a core material which is arranged to an axis portion thereof and is elastically deformable axially.

8. An actuator according to claim 7, wherein said core material is made of an elastomer.

9. An actuator according to claim 7, wherein said actuator element has a spiral tube member formed by winding spirally around said core material an extensible film which includes said dielectric film, a pair of said electrodes arranged on both the surfaces of said dielectric film, and an insulation film arranged on one of the surfaces of a pair of said electrodes.

10. An actuator according to claim 7, wherein said actuator element has a laminated tube member formed by laminating alternately around said core material said dielectric film and said electrodes in concentric circular shape.

11. An actuator according to claim 1, wherein said actuator element has a maximum diameter of less than 5 mm in a direction perpendicular to the axis.

12. An actuator according to claim 1, wherein a plurality of said actuator elements are bound and arranged.

13. An actuator according to claim 12, wherein at least one of a positive pole side and a negative pole side of a plurality of said electrodes of said bound actuator elements is shared in use.

14. An actuator according to claim 1, wherein said electrodes are made of a mixed material comprised of an elastomer and conductive material.

15. An actuator according to claim 1, wherein said electrodes are liquid.
